(19) Europäisches Patentamt
European Patent Office
Office européen des brevets

(11) **EP 3 899 453 B1**

(12) **EUROPÄISCHE PATENTSCHRIFT**

(45) Veröffentlichungstag und Bekanntmachung des Hinweises auf die Patenterteilung:
**18.10.2023 Patentblatt 2023/42**

(21) Anmeldenummer: **19808761.1**

(22) Anmeldetag: **21.11.2019**

(51) Internationale Patentklassifikation (IPC):
**G01F 23/28** (2006.01)    **G01F 25/20** (2022.01)
**G01F 25/00** (2022.01)    **G01S 7/52** (2006.01)
**G01S 7/40** (2006.01)    **G01S 15/88** (2006.01)
**G01S 13/88** (2006.01)    **G01R 31/36** (2020.01)
**B65B 57/14** (2006.01)    **B65B 3/30** (2006.01)

(52) Gemeinsame Patentklassifikation (CPC):
**G01F 23/28; B65B 3/30; B65B 57/145; G01F 25/24; G01R 31/3647; G01S 7/40; G01S 7/52004; G01S 13/88; G01S 15/88**

(86) Internationale Anmeldenummer:
**PCT/EP2019/082020**

(87) Internationale Veröffentlichungsnummer:
**WO 2020/126275 (25.06.2020 Gazette 2020/26)**

(54) **VERFAHREN ZUR ERMITTLUNG DER FUNKTIONSTÜCHTIGKEIT EINES FELDGERÄTES UND FÜLLSTANDSMESSGERÄT ZUR DURCHFÜHRUNG DES VERFAHRENS**

METHOD FOR DETERMINING THE OPERABILITY OF A FIELD DEVICE AND LEVEL MEASURING DEVICE FOR CARRYING OUT THE METHOD

PROCÉDURE DE DÉTERMINATION DU BON FONCTIONNEMENT D'UN APPAREIL DE TERRAIN ET APPAREIL DE MESURE DU NIVEAU DE REMPLISSAGE POUR LA MISE EN OEUVRE DE LA PROCÉDURE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **19.12.2018 DE 102018132870**

(43) Veröffentlichungstag der Anmeldung:
**27.10.2021 Patentblatt 2021/43**

(73) Patentinhaber: **Endress+Hauser SE+Co. KG**
**79689 Maulburg (DE)**

(72) Erfinder:
• **DAUFELD, Ghislain**
**68128 Village Neuf (FR)**
• **KEMPA, Arnd**
**79585 Steinen (DE)**
• **GORENFLO, Stefan**
**79688 Hausen (DE)**

(74) Vertreter: **Koslowski, Christine Adelheid**
**Endress+Hauser Group Services (Deutschland) AG+Co. KG**
**Colmarer Straße 6**
**79576 Weil am Rhein (DE)**

(56) Entgegenhaltungen:
**EP-A1- 0 665 443**    **DE-A1-102017 100 269**
**US-A1- 2007 205 772**

**Beschreibung**

Die Erfindung betrifft ein Verfahren zur Überprüfung der Funktionstüchtigkeit und der voraussichtlichen Restbetriebszeit eines Feldgerätes.

Feldgeräte werden in der Prozessautomatisierungstechnik eingesetzt, um entsprechende Prozessvariablen zu bestimmen. Hierzu basiert die Funktionsweise der Feldgeräte auf jeweils geeigneten Messprinzipien, um Prozessvariablen, wie Füllstand, Durchfluss, Druck, Temperatur, pH-Wert, Redoxpotential oder Leitfähigkeit zu erfassen. Verschiedenste solcher Feldgeräte-Typen werden von der Firma Endress + Hauser hergestellt und vertrieben.

Zur Füllstandsmessung von Füllgütern in Behältern haben sich Radar- und Ultraschallbasierte Messverfahren etabliert, da sie robust und wartungsarm sind. Ein zentraler Vorteil dieser Messverfahren besteht in der Fähigkeit, den Füllstand quasi kontinuierlich messen zu können. Im Kontext dieser Patentanmeldung bezieht sich der Begriff *"Radar"* auf Signale bzw. elektromagnetische Wellen mit Frequenzen zwischen 0.03 GHz und 300 GHz. Unter dem Begriff *"Ultraschall"* werden akustische Signale mit einer Frequenz zwischen 12 kHz und 10 MHz verstanden.

Allgemein kann durch interne Alterungseffekte oder durch äußere Umwelteinflüsse die Funktionstüchtigkeit von Feldgeräten mit fortschreitenden Betriebszeiten verloren gehen. Verursacht werden kann dies beispielsweise durch die Kapazitätsabnahme bei Puffer-Kondensatoren, durch Verstimmung von Oszillatoren oder durch Impedanz-Änderungen in Verstärker-Einheiten. Dies kann einerseits problematisch sein, wenn von außen nicht erkennbar ist, dass die Prozessgröße bzw. der Füllstand nicht mehr korrekt erfasst wird. Hierdurch können kritische Zustände in der Prozessanlage, wie eine Überfüllung des Behälters, hervorgerufen werden. Zum anderen kann ein unerwartet auftretender Funktionsausfall des Gerätes zu langen Stillstands-Zeiten der Prozessanlage führen, wodurch dem Betreiber ein erheblicher finanzieller Schaden entstehen kann.

Der Erfindung liegt daher die Aufgabe zugrunde, ein Verfahren bereitzustellen, mit dem die Funktionstüchtigkeit und die Restbetriebszeit des Feldgerätes überwacht werden kann. Schaltungsanordnung und Verfahren zur Überwachung der Funktion eines Vibrationsgrenzschalters und/oder eines Füllstandsmessgerätes sind im Stand der Technik bekannt, siehe z.B. US 2007 205 772 A1.

Die Erfindung löst diese Aufgabe durch ein Verfahren zur Ermittlung der Funktionstüchtigkeit eines Feldgerätes, das zur Messung einer Prozessgröße zumindest eine elektronische Einheit umfasst. Dabei wird zumindest die elektronische Einheit von einem Energiespeicher des Feldgerätes versorgt. Folgende Verfahrensschritte umfasst das Verfahren:

-    Messung der Kapazität des Energiespeichers nach Abschalten der zumindest einen elektronischen Einheit, und

-    Messung der Leistungsentnahme am Energiespeicher nach Einschalten der zumindest einen elektronischen Einheit.

Erfindungsgemäß wird das Feldgerät als nicht funktionstüchtig eingestuft, sofern die Kapazität des Energiespeichers eine definierte Mindestkapazität unterschreitet, und sofern die Leistungsentnahme von einem vordefinierten Normal-Verbrauch abweicht. Da die Kapazität des Energiespeichers oftmals von der Temperatur am Füllstandsmessgerät abhängt, ist es je nach Einsatzgebiet des Feldgerätes gegebenenfalls vorteilhaft, wenn am Feldgerät die Temperatur gemessen wird, und wenn die erlaubte Mindest-Kapazität des Energiespeichers als eine Funktion, die von der gemessenen Temperatur abhängig ist, definiert ist.

Vorteilhaft an den erfindungsgemäßen Verfahren ist, dass das Feldgerät seine Funktionsfähigkeit selber diagnostizieren kann, so dass es dies im Zweifelsfall anzeigen oder einer übergeordneten Prozessleitstelle melden kann. Zudem kann nicht nur diagnostiziert werden, ob das Feldgerät insgesamt funktionsuntauglich ist. Es kann zudem geprüft werden, welche der einzelnen Komponenten defekt ist und somit den Funktionsausfall des Feldgerätes hervorruft. Im Falle einer unterschrittenen Mindest-Kapazität gilt der Energie-Speicher als defekt. Sofern die gemessene Leistungsentnahme vom Normal-Verbrauch abweicht, ist eine der elektrischen Einheiten, die durch den Energiespeicher versorgt werden, als defekt anzusehen.

Erfindungsgemäß ist es nicht fest vorgeschrieben, wie die Kapazität des Energiespeichers bzw. die Leistungsentnahme am Energiespeicher gemessen wird. Die Kapazität kann beispielsweise gemessen werden, indem während einer definierten Entladung des Energiespeichers ein zeitlicher Spannungsabfall am Energiespeicher gemessen wird. Daraus lässt sich gemäß

$$U_2 = U_1 * e^{-\frac{t}{R*C}}$$

die Kapazität herleiten.

Auch die Leistungsentnahme am Energiespeicher kann mittels Messung des Spannungsabfalls bestimmt werden: So kann nach Einschalten der zu überprüfenden elektronischen Einheit während einer definierten Zeitspanne, in der alle anderen vom Energiespeicher gespeisten elektronischen Einheiten des Feldgerätes ausgeschaltet sind, der zeitliche Spannungsabfall am Energiespeicher gemessen werden, gemäß:

$$p_{11,12} = C * \frac{(U_1 - U_2)^2}{2 * t}$$

Das Feldgerät ist im Falle der Spannungsmessung dementsprechend als nicht funktionstüchtig einzustufen, sofern der gemessene Spannungsabfall einen vordefinierten Maximal-Spannungsabfall überschreitet.

Auf Basis des erfindungsgemäßen Verfahrens kann neben der reinen Diagnose gemäß dem Prinzip der "*Predictive Maintenance*" zudem eine Prognose erstellt werden, wieviel Restbetriebszeit bis zu einem etwaigen Funktionsausfall des Füllstandsmessgerätes verbleibt, sofern das Füllstandsmessgerät aktuell noch funktionstüchtig ist. Dabei kann die Prognose auf Basis der voraussichtlichen Restbetriebszeit des Energiespeichers oder auch auf Basis der erwarteten Restbetriebszeit der elektronischen Einheiten erstellt werden. Im Falle des Energiespeichers kann beispielsweise für den Fall, dass die Kapazität des Energiespeichers die definierte Mindest-Kapazität aktuell noch nicht unterschreitet, über fortlaufende Messzyklen eine Änderungsfunktion der Kapazität ermittelt werden. Erfolgen kann dies, indem die über die Messzyklen (in denen die Prozessgröße bestimmt wird) gemessenen Kapazitäten durch eine geeignete mathematische Funktion approximiert werden. Anhand der aktuellen Kapazität sowie anhand der Kapazitäts-Änderungsfunktion kann somit eine Restbetriebszeit bis zum Unterschreiten der Mindestkapazität berechnet werden.

Analog zur Restbetriebszeit des Energiespeichers kann auch für eine der elektronischen Einheiten über fortschreitende Messzyklen eine entsprechende Änderungsfunktion der Leistungsentnahme ermittelt werden, indem die über die Messzyklen gemessenen Leistungsentnahmen durch eine geeignete mathematische Funktion approximiert werden. Voraussetzung hierfür ist wiederum, dass die Leistungsentnahme am Energiespeicher aktuell noch nicht signifikant vom Normal-Verbrauch abweicht. Es versteht sich von selbst, dass zur Bestimmung der voraussichtlichen Restbetriebszeit der jeweiligen elektronischen Einheit während der Leistungsentnahme nur die jeweilige elektronische Einheit durch den Energiespeicher gespeist werden darf. Alle weiteren Einheiten sind während der Leistungsentnahme entsprechend abzuschalten. Somit kann anhand der aktuellen Leistungsentnahme sowie anhand der korrespondierenden Änderungsfunktion eine zweite Restbetriebszeit bis zum Überschreiten einer Mindest-Abweichung zum Normal-Verbrauch berechnet werden.

Je nachdem, welche der berechneten Restbetriebszeiten (also die Restbetriebszeit des Energiespeichers oder die Restbetriebszeit einer der elektronischen Einheiten) geringer ausfällt, kann die geringste Restbetriebszeit als maßgebliche Restbetriebszeit bis zum voraussichtlichen Funktionsausfall des Feldgerätes definiert werden.

Sofern die voraussichtliche Restbetriebszeit des Feldgerätes nicht auf Basis der Funktionstüchtigkeit einzelner Komponenten bestimmt werden soll, ist es auch möglich, die Restbetriebszeit lediglich auf Basis des Spannungsabfalls am Energiespeicher (während der Kapazitätsmessung oder während der Messung der Leistungsentnahme) zu bestimmen. Voraussetzung hierfür ist abermals, dass der gemessene Spannungsabfall den vordefinierten Maximal-Spannungsabfall noch nicht überschritten hat. Über fortschreitende Messzyklen ist dementsprechend eine Änderungsfunktion des Spannungsabfalls zu ermitteln, indem die über fortschreitende Messzyklen die jeweils gemessenen Spannungsabfälle durch eine geeignete mathematische Funktion approximiert werden. Anhand des aktuellen Wertes des Spannungsabfalls, sowie anhand der entsprechenden Änderungsfunktion kann somit die Restbetriebszeit bis zum Überschreiten des Maximal-Spannungsabfalls, also bis zum Funktionsausfall des Feldgerätes berechnet werden. Unabhängig davon, auf welcher Basis die Änderungsfunktion erstellt wurde, kann ein geeigneter Funktionstyp für die jeweilige der Änderungsfunktion beispielsweise mittels der Methode der kleinsten Quadrate (im Englischen bekannt unter "*Least Squares*") ermittelt werden.

Korrespondierend zum erfindungsgemäßen Verfahren wird die Aufgabe, die der Erfindung zugrunde liegt, durch ein Radar-basiertes Füllstandsmessgerät gelöst, das zur Messung eines in einem Behälter befindlichen Füllgutes dient. Zur Durchführung des Verfahrens umfasst das Füllstandsmessgerät folgende Komponenten:

- Einen Energiespeicher,
- eine vom Energiespeicher gespeiste Signalerzeugungs-Einheit, die ausgelegt ist, ein Radar- oder Ultraschall-Signal in Richtung des Füllgutes auszusenden,
- eine vom Energiespeicher gespeiste Auswertungs-Einheit, die ausgelegt ist, anhand des an der Füllgut-Oberfläche reflektierten Signals den Füllstand zu bestimmen,
- eine Steuerungs-Einheit, die konzipiert ist, um

  o die Signalerzeugungs-Einheit und/oder die Auswertungs-Einheit bzw. einzelne Funktionsblöcke hiervon an- und abzuschalten,
  o die Leistungsentnahme am Energiespeicher zu ermitteln, und
  o die Kapazität des Energiespeichers zu bestimmen, und
  o um das Feldgerät als nicht funktionstüchtig einzustufen, sofern die Kapazität des Energiespeichers die Mindestkapazität unterschreitet, oder sofern die Leistungsentnahme vom definierten Normal-Verbrauch abweicht.

Zwecks Erstellung einer Prognose bis zur Funktionsuntüchtigkeit ist es von Vorteil, wenn die Steuerungs-Einheit ausgelegt ist, auf Basis der gemessenen Kapazität und/oder auf Basis der gemessenen Leistungsentnahme eine entsprechende Restbetriebszeit zu ermitteln, sofern die Steuerungs-Einheit das Füllstandsmessgerät aktuell als funktionstüchtig einstuft. In diesem Zusammenhang ist es ebenfalls vorteilhaft, wenn die Steuerungs-Einheit ausgelegt ist, eine etwaige Funktionsuntüchtigkeit oder eine voraussichtliche Restbetriebszeit an eine übergeordnete Einheit, wie eine Prozessleitstelle zu übermitteln. Das erfindungsgemäße Verfahren bietet sich insbesondere dann an, wenn der Energiespeicher als Puffer-Kondensator ausgelegt ist, da Kondensatoren mit zunehmenden Messzyklen entsprechende Degradations-Erscheinungen zeigen. Zwecks Wiederbeladung des Energiespeichers kann das Füllstandsmessgerät beispielsweise so ausgelegt werden, dass der Energiespeicher mit der übergeordneten Einheit verbindbar ist.

Unter dem Begriff "*Einheit*" wird im Rahmen der Erfindung prinzipiell eine elektronische Schaltung verstanden, die für ihren Einsatzzweck geeignet ausgelegt ist. Es kann sich also je nach Anforderung um eine Analogschaltung zur Erzeugung bzw. Verarbeitung entsprechender analoger Signale handeln. Es kann sich jedoch auch um eine (halbleiterbasierte) Digitalschaltung wie einem FPGA oder einen Speichermedium in Zusammenwirken mit einem Programm handeln. Dabei ist das Programm ausgelegt, die entsprechenden Verfahrensschritte durchzuführen bzw. die notwendigen Rechenoperationen der jeweiligen Einheit anzuwenden. In diesem Kontext können verschiedene elektronische Einheiten des Füllstandsmessgerätes im Sinne der Erfindung potentiell auch auf einen gemeinsamen physikalischen Speicher zurückgreifen bzw. mittels derselben physikalischen Digitalschaltung betrieben werden.

Anhand der nachfolgenden Figuren wird die Erfindung näher erläutert. Es zeigt:

    Fig. 1: Eine typische Anordnung eines Radar- oder Ultraschall-basierten Füllstandsmessgerätes,

    Fig. 2: einen schaltungstechnischen Aufbau des Füllstandsmessgerätes,

    Fig. 3: einen schematischen Ablauf des erfindungsgemäßen Verfahrens, und

    Fig. 4: eine Berechnung der Restbetriebszeit bis zur Funktionsuntüchtigkeit

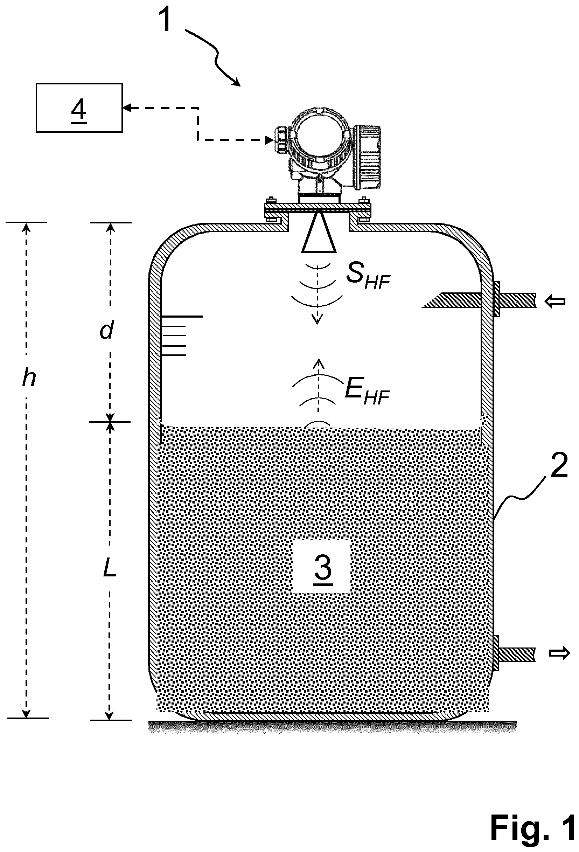

Das erfindungsgemäße Verfahren zur Beurteilung der Funktionstüchtigkeit von Feldgeräten wird im Folgenden am Beispiel von Füllstandsmessung näher verdeutlicht. Zum grundsätzlichen Verständnis ist in Fig. 1 daher eine typische Anordnung eines Radar- oder Ultraschall-basierten Füllstandsmessgerätes 1 an einem Behälter 2 gezeigt. In dem Behälter 2 befindet sich ein Füllgut 3, dessen Füllstand L durch das Füllstandsmessgerät 1 zu bestimmen ist. Dazu ist das Füllstandsmessgerät 1 oberhalb des maximal zulässigen Füllstands L am Behälter 2 angebracht. Je nach Einsatzgebiet kann die Höhe h des Behälters 2 bis zu 125 m betragen.

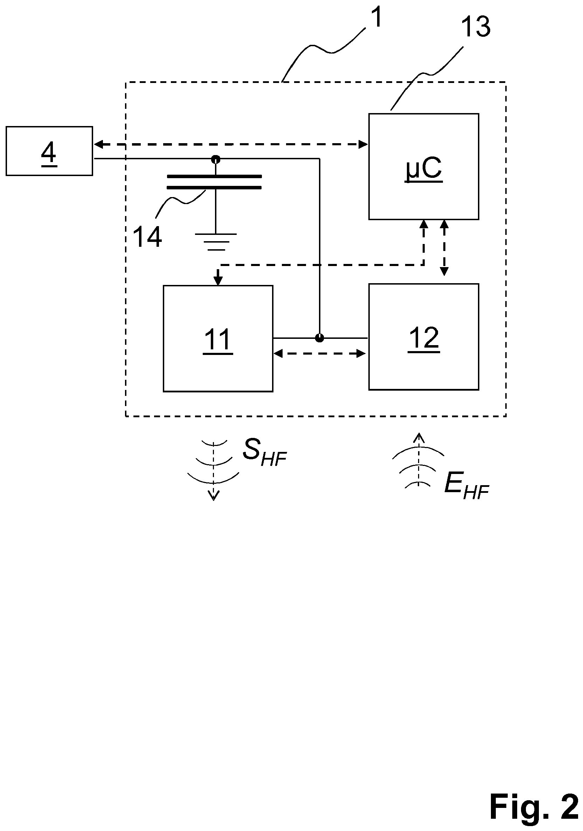

Das Füllstandsmessgerät 1 ist so ausgerichtet, dass von einer Signalerzeugungs-Einheit 11 (vgl. Fig. 2) erzeugte Radar- oder Ultraschall-Signale $S_{HF}$ in Richtung des Füllgutes 3 ausgesendet werden. An der Oberfläche des Füllgutes 3 werden die Signale $E_{HF}$ reflektiert und nach einer korrespondierenden Signallaufzeit von einer Auswertungs-Einheit 12 des Füllstands-Messgerätes 1 empfangen. Hierbei hängt die Signallaufzeit der Signale $S_{HF}$, $E_{HF}$ von der Entfernung d = h - L des Füllstandsmessgerätes 1 zur Füllgut-Oberfläche ab.

Wie Feldgeräte im Allgemeinen ist auch das Füllstandsmessgerät in Fig. 1 über ein Bussystem mit einer übergeordneten Einheit 4, beispielsweise einem Prozessleitsystem oder einer dezentralen Datenbank verbunden. Hierüber können zum einen Informationen über den Betriebszustand kommuniziert werden. Über das Bussystem können jedoch auch Informationen über die gemessene Prozessgröße bzw. den gemessenen Füllstand L übermittelt werden, um gegebenenfalls am Behälter 2 vorhandene Zu- oder Abflüsse zu steuern. Auch die Energieversorgung des Füllstandsmessgerätes 1 erfolgt je nach Auslegung über das Bussystem. Da das Füllstandsmessgerät 1 oftmals in explosionsgefährdeten Anlagen eingesetzt wird, ist die entsprechende Schnittstelle des Füllstandsmessgerätes 1 in der Regel leistungsbegrenzt ausgelegt. Dementsprechend kann die Schnittstelle beispielsweise konzipiert sein, mittels leistungssparenden Protokollen wie etwa "Ethernet", "PROFIBUS", "HART" oder "Wireless HART" zu kommunizieren.

Um für die eigentliche Messung periodisch kurzzeitig genügend Leistung vorhalten zu können, ist das Füllstandsmessgerät 1 bzw. das Feldgerät allgemein in der Regel über einen Puffer-Kondensator 14 oder einen äquivalenten Energiespeicher mit der übergeordneten Einheit 4 verbunden. Bei dem in Fig. 2 dargestellten Schaltungsaufbau des Füllstandsmessgerätes 1 werden die Signalerzeugungs-Einheit 11 und die Auswertungs-Einheit 12 daher über den Puffer-Kondensator 14 mit Leistung versorgt. Durchgehende Linien spiegeln hierbei die Leistungsversorgung wieder, gestrichelte Linien die Datenübertragung. Dabei kann auch die Leistungsversorgung weiterer elektronischer Einheiten über den Puffer-Kondensator 14 erfolgen. Damit sich der Puffer-Kondensator 14 zwischen den einzelnen Messungen wiederaufladen kann, ist das Füllstandsmessgerät 1 so ausgelegt, dass es die Taktrate $f_c$, mit der es den Füllstand L jeweils neu misst, in Abhängigkeit des Ladezustandes des Puffer-Kondensators 14 steuert. Je höher der Ladezustand des Kondensators 14 ist, desto öfter wird der Füllstand L bzw. allgemein die Prozessgröße gemessen.

Mit fortschreitenden Messzyklen des Füllstandsmessgerätes 1 steigt die Gefahr, dass der Puffer-Kondensator 14 oder auch die elektronischen Einheiten 11, 12, degradieren. So kann sich die Kapazität des Puffer-Kondensators 14 mit zunehmendem Alter verringern. Im Fall der elektronischen Einheiten 11, 12, können sich bspw. Oszillatoren verstimmen oder Kurzschlüsse können auftreten. Je nach Schaltungs-Einheit 11, 12 kann dies dazu führen, dass ein falscher Füllstand L ermittelt wird, ohne dass dies von außen ersichtlich ist. Dies birgt die Gefahr, aufgrund des falschen Füllstandswertes hieran gekoppelte Aktoren der Prozessanlage, wie Pumpen oder Auslässe am Behälter 2, falsch zu steuern.

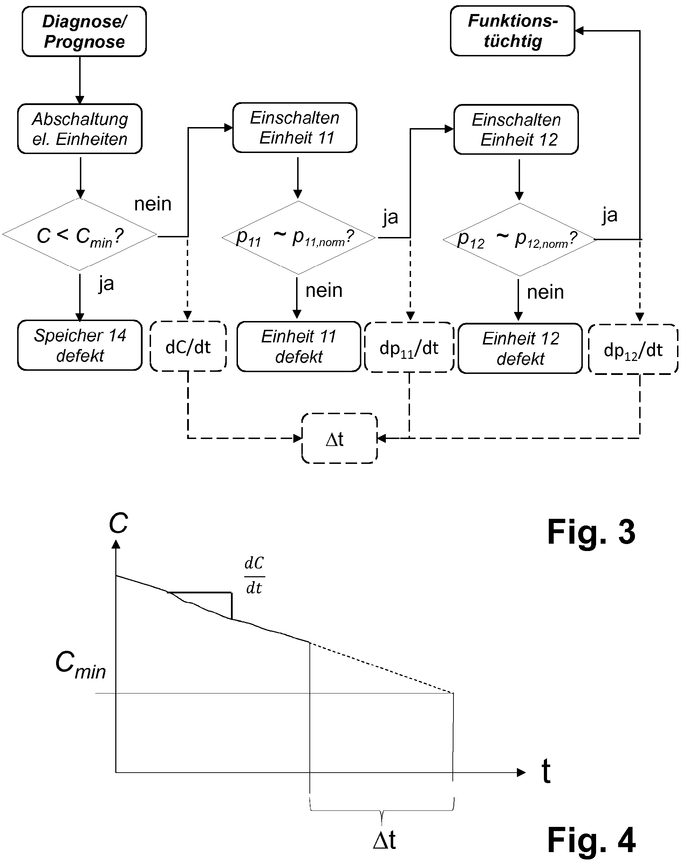

Mithilfe des erfindungsgemäßen Verfahrens, das in Fig. 3 dargestellt ist, kann dies verhindert werden: Zum einen kann diagnostiziert werden, ob das Füllstandsmessgerät 1 noch funktionstüchtig ist. Wenn dies der Fall ist, kann auf Basis außerdem eine Restbetriebszeit Δt bis zur vermutlichen Funktionsuntüchtigkeit prognostiziert werden.

Zur Prüfung der Funktionstüchtigkeit schaltet die Steuerungs-Einheit 13 des Füllstandsmessgerätes 1 zunächst alle elektronischen Einheiten 11, 12, die vom Puffer-Kondensator 14 gespeist werden, ab und misst die Kapazität C des Puffer-Kondensators 14. Zur Bestimmung der Kapazität C in Farad kann die Steuerungs-Einheit 13 bspw. für eine definierte Zeit t unter einem bekannten Entladewiderstand R die Entladespannung $(U_1 - U_2)$ des Puffer-Kondensators 14 aufnehmen, um hieraus gemäß

$$U_2 = U_1 * e^{-\frac{t}{R*C}}$$

die Kapazität C zu bestimmen. Wenn der Puffer-Kondensator 14 die zuvor definierte Mindestkapazität $C_{min}$ unterschreitet, ist der Puffer-Kondensator 14 und somit das Füllstandsmessgerät 1 als nicht funktionstüchtig einzustufen.

Da je nach Auslegung des Kondensators 14 bzw. des Energiespeichers dessen Kapazität C auch von der Umgebungstemperatur abhängt, kann die die Mindestkapazität $C_{min}$ in der Steuer-Einheit 13 als eine von der Temperatur abhängige Funktion hinterlegt sein, bspw. in Form einer Look-Up Table. Solch eine Auslegung erfordert, dass das Füllstandsmessgerät 1 zusätzlich einen Temperatur-Sensor zur Erfassung der aktuellen Temperatur umfasst.

Sofern der Puffer-Kondensator 14 die Mindestkapazität $C_{min}$ nicht unterschreitet, scheidet er als Fehlerquelle aus. In diesem Fall kann der ermittelte Kapazitätswert C pro Messzyklus chronologisch abgespeichert werden, um aus den über die Messzyklen abgespeicherten Werten eine zeitliche Änderungs-Funktion dC/dt des Kapazitätswertes C zu erstellen.

Zumindest bei intaktem Puffer-Kondensator 14 sieht das erfindungsgemäße Verfahren vor, die Leistungsentnahme $p_{11}$, $p_{12}$ am Puffer-Kondensator 14 zu messen. Hierzu wird eine der abgeschalteten elektronischen Einheiten 11, 12 wieder eingeschaltet, um in diesem Zustand die Leistungsentnahme $p_{11}$ am Puffer-Kondensator 14 zu messen. Da lediglich die wiedereingeschaltete elektronische Einheit 11 zum Leistungsverbrauch beiträgt, kann die am Puffer-Kondensator 14 gemessene Leistungsentnahme $p_{11}$ dem Leistungsverbrauch der wiedereingeschalteten Signalerzeugungs-Einheit 11 zugeordnet werden.

Der Leistungsverbrauch $p_{11}$ kann wiederum durch Messung des zeitlichen Spannungsabfalls $U_1 - U_2$ am Puffer-Kondensator 14, nach Einschalten der Signalerzeugungs-Einheit 11 bestimmt werden, anhand

$$p_{11,12} = C * \frac{(U_1 - U_2)^2}{2 * t}$$

Die Zeit t entspricht hierbei der Messzeit, bzw. der Zeit, während derer die Signalerzeugungs-Einheit 11 angeschaltet ist.

Den ermittelten Leistungsverbrauch $p_{11}$ kann die Steuer-Einheit 13 außerdem mit einem bekannten Normal-Verbrauch $p_{norm}$ der Signalerzeugungs-Einheit 11 vergleichen. Sofern der Leistungsverbrauch $p_{11}$ vom Normal-Verbrauch $p_{norm}$ signifikant abweicht, ist die wiedereingeschaltete elektronische Einheit 11 und wiederum auch das gesamte Füllstandsmessgerät 1 erfindungsgemäß als nicht funktionstüchtig einzustufen.

Analog hierzu kann mit der zweiten elektronischen Einheit 12 bzw. mit jeder weiteren elektronischen Einheit, die vom Puffer-Kondensator 14 gespeist wird, vorgegangen werden, wenn der Leistungsverbrauch $p_{11}$ der zuerst wiedereingeschalteten elektronischen Einheit 11 (bzw. aller zuvor eingeschalteten Einheiten) nicht signifikant vom Normal-Verbrauch $p_{norm}$ abweicht:

- Wiedereinschalten der zweiten bzw. weiteren elektronischen Einheit 12 (hierbei kann die zuerst eingeschaltete Einheit 11 entweder eingeschaltet bleiben oder ausgeschaltet werden)
- Messung des Leistungsentnahme $p_{12}$ am Pufferkondensator 14, und
- Einstufung der als zweites eingeschalteten elektronischen Einheit 12 als nicht funktionstüchtig, sofern deren Leistungsverbrauch $p_{12}$ vom entsprechenden Normal-Verbrauch $p_{norm}$ abweicht.

Je nachdem, ob und welche der Komponenten 11, 12, 14 des Füllstandsmessgerätes 1 als nicht funktionstüchtig eingestuft wurden, kann die Funktionsuntüchtigkeit über die Schnittstelle der übergeordneten Einheit 4 mitgeteilt werden. Es versteht sich von selbst, dass die erfindungsgemäßen Verfahrensschritte, die in Fig. 1 und Fig. 2 in Bezug zum Füllstandsmessgerät 1 erläutert sind, gleichermaßen allgemein für jeden Typ Feldgerät anwendbar sind, bei dem die Taktrate $f_c$, mit der die jeweilige Prozessgröße gemessen wird, in Abhängigkeit des Ladezustandes des zugrundeliegenden Energiespeichers geregelt ist.

Wie aus Fig. 3 weiterhin hervorgeht, kann nicht nur für den Puffer-Kondensator 14, sondern auch für die Signalerzeugungs-Einheit 11 bzw. für die Auswertungs-Einheit 12 der ermittelte Leistungsverbrauch $p_{11}$, $p_{12}$ mit zunehmenden Messzyklen chronologisch abgespeichert werden (sofern das Füllstandsmessgerät 1 noch als funktionstüchtig eingestuft ist), um auf dieser Basis analog zur Kapazität C eine Änderungsfunktion $dp_{11,12}/dt$ des Leistungsverbrauchs zu erstellen.

Genutzt werden können die Änderungsfunktionen dp/dt, dC/dt, um neben der Diagnose der Funktionstüchtigkeit zudem eine Prognose zu erstellen, wann das Füllstandsmessgerät 1 voraussichtlich nicht mehr funktionstüchtig sein wird. Genutzt werden kann solch eine Voraussage, um gemäß dem Prinzip der *"Predictive Maintenance"* von Seiten des Anlagenbetreibers frühzeitig eine Wartung bzw. einen Austausch des Füllstandsmessgerätes 1 einplanen zu können.

Berechnet werden kann eine voraussichtliche Restbetriebszeit $\Delta t$ bis zur Funktionsuntüchtigkeit im Falle des Puffer-Kondensators 14, indem die Steuer-Einheit 13 anhand des aktuellen Kapazitäts-Wertes C und anhand der ermittelten Änderungsfunktion dC/dt die korrespondierende Restbetriebszeit $\Delta t_1$ bis zum voraussichtlichen Erreichen der Mindest-Kapazität $C_{min}$ berechnet.

Schematisch dargestellt ist die Bestimmung der Restbetriebszeit $\Delta t$ am Beispiel des Puffer-Kondensators 14 in Fig. 4: Hier ist zur Veranschaulichung ein in etwa linearer Abfall der Kapazität C des Puffer-Kondensators 14 mit fortschreitender Betriebszeit des Füllstandsmessgerätes 1 dargestellt. Dementsprechend kann bei dem in Fig. 4 gezeigten Ausführungsbeispiel als Funktionstyp der Änderungsfunktion dC/dt eine Geraden-Funktion herangezogen werden. Allgemein lässt sich die Änderungsfunktion dC/dt jedoch durch eine Geraden-Funktion gegebenenfalls nicht optimal approximieren, so dass beispielsweise eine polynomielle Funktion eine verbesserte Approximation an den Verlauf der Kapazität K über die vergangenen Messzyklen liefern würde. Dementsprechend kann die Steuerungs-Einheit 13 beispielsweise so programmiert werden, dass sie einen geeigneten Funktionstyp der entsprechenden Änderungsfunktion dC/dt mittels der Methode der kleinsten Quadrate ermittelt. Hierdurch wird die verbleibende Restbetriebszeit $\Delta t$ des Feldgerätes noch genauer voraussagbar.

Obwohl in Fig. 4 die Erstellung der Änderungsfunktion dC/dt nur am Beispiel des Puffer-Kondensators 14 veranschaulicht ist, lässt sich auf Basis der in Fig. 4 beschriebenen Methodik ebenfalls eine etwaige Änderungsfunktion $dp_{11,12}/dt$ der Signalerzeugungs-Einheit 11 bzw. der Auswertungs-Einheit 12 erstellen, um hieraus wiederum eine eigene Restbetriebszeit $\Delta t_{2,3}$ ableiten. Auch die Erstellung einer Änderungsfunktion dU/dt auf Basis der gemessenen Spannungsabfälle $U_1 - U_2$ am Puffer-Kondensator 14 ist denkbar, sofern die Leistungsentnahme $p_{11}$ bzw. die Kapazität C auf Basis des zeitlichen Spannungsabfalls $U_1 - U_2$ gemessen wird.

Für den Fall, dass sowohl auf Basis des Puffer-Kondensators 14, als auch auf Basis einer der elektronischen Einheiten 11, 12 jeweils eine separate Restbetriebszeit $\Delta t$ berechnet wird, kann die Steuerungs-Einheit 13 beispielsweise die geringste der ermittelten Restbetriebszeiten $\Delta t_{1,2,3}$ als relevante Restbetriebszeit $\Delta t$ bis zur Funktionsuntüchtigkeit des Füllstandsmessgerätes 1 definieren.

## Bezugszeichenliste

| | |
|---|---|
| 1 | Feldgerät bzw. Füllstandsmessgerät |
| 2 | Behälter |
| 3 | Füllgut |
| 4 | Übergeordnete Einheit |
| 11 | Signalerzeugungs-Einheit |
| 12 | Auswertungs-Einheit |
| 13 | Steuerungs-Einheit |
| 14 | Energiespeicher |
| C | Kapazität |
| $C_{min}$ | Mindest-Kapazität |
| d | Entfernung |
| $E_{HF}$ | Reflektierte Signale |
| h | Einbauhöhe |
| L | Prozessgröße bzw. Füllstand |
| $P_{11,12}$ | Leistungsentnahme |
| $p_{norm}$ | Normal-Verbrauch |
| $S_{HF}$ | Ausgesendete Signale |
| $U_{1,2}$ | Spannungen |
| $\Delta U_{max}$ | Maximal-Spannungsabfall |
| $\Delta t$ | Restbetriebszeit |
| dC,p,U/dt | Änderungsfunktionen |

## Patentansprüche

1. Verfahren zur Ermittlung der Funktionstüchtigkeit eines Feldgerätes (1), das zur Messung einer Prozessgröße (L) zumindest eine elektronische Einheit (11, 12) umfasst, wobei die zumindest eine elektronische Einheit (11, 12) mittels eines Energiespeichers (14) des Feldgerätes (1) versorgt wird, folgende Verfahrensschritte umfassend:

   - Messung der Kapazität (C) des Energiespeichers (14) nach Abschalten der zumindest einen elektronischen Einheit (11, 12), und
   - Messung der Leistungsentnahme ($p_{11}$, $p_{12}$) am Energiespeicher (14) nach Einschalten der zumindest einen elektronischen Einheit (11, 12),

   wobei das Feldgerät (1) als nicht funktionstüchtig eingestuft wird, sofern die Kapazität (C) des Energiespeichers (14) eine definierte Mindestkapazität ($C_{min}$) unterschreitet, und sofern die Leistungsentnahme ($p_{11}$, $p_{12}$) von einem vordefinierten Normal-Verbrauch ($p_{norm}$) abweicht.

2. Verfahren nach Anspruch 1, wobei die Kapazität (C) gemessen wird, indem während einer definierten Entladung des Energiespeichers (14) ein zeitlicher Spannungsabfall ($U_2 - U_1$) am Energiespeicher (14) gemessen wird.

**3.** Verfahren nach Anspruch 1 oder 2, wobei zur Messung der Leistungsentnahme ($p_{11}$, $p_{12}$) am Energiespeicher (14) nach Einschalten der zumindest einen elektronischen Einheit (11, 12) der zeitliche Spannungsabfall ($U_2$- $U_1$) gemessen wird.

**4.** Verfahren nach Anspruch 2 oder 3, wobei das Feldgerät (1) als nicht funktionstüchtig eingestuft wird, sofern der gemessene Spannungsabfall ($U_2$- $U_1$) einen vordefinierten Maximal-Spannungsabfall ($\Delta U_{max}$) überschreitet.

**5.** Verfahren nach einem der vorhergehenden Ansprüche, wobei für den Fall, dass die Kapazität (C) des Energiespeichers (14) die definierte Mindest-Kapazität ($C_{min}$) nicht unterschreitet, über fortschreitende Messzyklen eine erste Änderungsfunktion (dC/dt) der Kapazität (C) ermittelt wird, und wobei anhand der aktuellen Kapazität (C) sowie anhand der Änderungsfunktion (dC/dt) eine erste Restbetriebzeit ($\Delta t_1$) bis zum Unterschreiten der Mindestkapazität ($C_{min}$) berechnet wird.

**6.** Verfahren nach zumindest einem der vorhergehenden Ansprüche, wobei für den Fall, dass die Leistungsentnahme ($p_{11}$, $p_{12}$) am Energiespeicher (14) nicht vom definierten Normal-Verbrauch ($p_{norm}$) abweicht, über fortschreitende Messzyklen eine zweite Änderungsfunktion (dp/dt) der Leitungsentnahme ($p_{11}$, $p_{12}$) ermittelt wird, und wobei anhand der aktuellen Leistungsentnahme ($p_{11}$, $p_{12}$) sowie anhand der zweiten Änderungsfunktion (dp/dt) eine zweite Restbetriebszeit ($\Delta t_2$) bis zum Überschreiten einer Mindest-Abweichung zum Normal-Verbrauch ($p_{min}$) berechnet wird.

**7.** Verfahren nach Anspruch 4, wobei für den Fall, dass der gemessene Spannungsabfall ($U_2$- $U_1$) den vordefinierten Maximal-Spannungsabfall ($\Delta U_{max}$) nicht überschreitet, über fortschreitende Messzyklen eine dritte Änderungsfunktion (dU/dt) des Spannungsabfalls ($U_2$- $U_1$) ermittelt wird, und wobei anhand des aktuellen Spannungsabfalls ($U_1$ - $U_2$) sowie anhand der dritten Änderungsfunktion (dU/dt) eine dritte Restbetriebszeit ($\Delta t_3$) bis zum Überschreiten des Maximal-Spannungsabfalls ($\Delta U_{max}$) berechnet wird.

**8.** Verfahren nach Anspruch 5, 6 oder 7, wobei ein geeigneter Funktionstyp der ersten Änderungsfunktion (dC/dt), der zweiten Änderungsfunktion (dp/dt) und/oder der dritten Änderungsfunktion (dU/dt) mittels der Methode der kleinsten Quadrate ermittelt wird.

**9.** Verfahren nach einem der vorhergehenden Ansprüche, wobei am Feldgerät (1) eine Temperatur gemessen wird, und wobei die Mindestkapazität ($C_{min}$) als eine von der Temperatur abhängige Funktion ($C_{min}$(T)) definiert ist.

**10.** Füllstandsmessgerät zur Durchführung des Verfahrens nach zumindest einem der vorhergehenden Ansprüche, wobei das Füllstandsmessgerät (1) zur Messung eines in einem Behälter (2) befindlichen Füllgutes (3) folgende Komponenten umfasst:

- Einen Energiespeicher (14),
- eine vom Energiespeicher (14) gespeiste Signalerzeugungs-Einheit (11), die ausgelegt ist, ein Radar- oder Ultraschall-Signal ($S_{HF}$) in Richtung des Füllgutes (3) auszusenden,
- eine vom Energiespeicher (14) gespeiste Auswertungs-Einheit (12), die ausgelegt ist, anhand des an der Füllgut-Oberfläche reflektierten Signals ($E_{HF}$) den Füllstand (L) zu bestimmen,
- eine Steuerungs-Einheit (13), die konzipiert ist, um

o die Signalerzeugungs-Einheit (11) und/oder die Auswertungs-Einheit (12) bzw. einzelne Funktionsblöcke hiervon an- und abzuschalten,
o die Leistungsentnahme ($p_{11}$, $p_{12}$) am Energiespeicher (14) zu ermitteln, und
o die Kapazität (C) des Energiespeichers (14) zu bestimmen, und
o um das Feldgerät (1) als nicht funktionstüchtig einzustufen, sofern die Kapazität (C) des Energiespeichers (14) die Mindestkapazität ($C_{min}$) unterschreitet, oder sofern die Leistungsentnahme ($p_{11}$, $p_{12}$) vom definierten Normal-Verbrauch ($p_{norm}$) abweicht.

**11.** Füllstandsmessgerät nach Anspruch 10, wobei die Steuerungs-Einheit (13) ausgelegt ist, auf Basis der gemessenen Kapazität (C) und/oder auf Basis der gemessenen Leistungsentnahme ($p_{11}$, $p_{12}$) eine Restbetriebszeit ($\Delta t_1$, $\Delta t_2$) bis zur Funktionsuntüchtigkeit des Füllstandsmessgerätes (1) zu berechnen, sofern die Steuerungs-Einheit (13) das Füllstandsmessgerät (1) aktuell als funktionstüchtig einstuft.

**12.** Füllstandsmessgerät nach Anspruch 10 oder 11, wobei die Steuerungs-Einheit (13) ausgelegt ist, eine etwaige Funktionsuntüchtigkeit oder eine Restbetriebszeit ($\Delta t_1$, $\Delta t_2$) an eine übergeordnete Einheit (4) zu übermitteln.

**13.** Füllstandsmessgerät nach einem der Ansprüche 10 bis 12, wobei der Energiespeicher (14) als Puffer-Kondensator ausgelegt ist, der zur Wiederbeladung insbesondere mit der übergeordneten Einheit (4) verbindbar ist.

## Claims

1.  A method for determining the functionality of a field device (1) which comprises at least one electronic unit (11, 12) for measuring a process variable (L),

    wherein the at least one electronic unit (11, 12) is supplied with power by an energy storage unit (14) of the field device (1), comprising the following process steps:

    - Measuring the capacitance (C) of the energy storage unit (14) after switching off the at least one electronic unit (11, 12), and
    - Measuring the power consumption ($p_{11}$, $p_{12}$) at the energy storage unit (14) after switching on the at least one electronic unit (11, 12),

    wherein the field device (1) is classified as non-functional if the capacitance (C) of the energy storage unit (14) drops below a defined minimum capacitance ($C_{min}$), and if the power consumption ($p_{11}$, $p_{12}$) deviates from a predefined standard consumption ($p_{norm}$).

2.  The method as claimed in claim 1, wherein the capacitance (C) is measured by measuring a voltage drop ($U_2$ - $U_1$) at the energy storage unit (14) over time during a defined discharge of the energy storage unit (14).

3.  The method as claimed in claim 1 or 2, wherein the voltage drop ($U_2$ - $U_1$) over time is measured in order to measure the power consumption ($p_{11}$, $p_{12}$) at the energy storage unit (14) after switching on the at least one electronic unit (11, 12).

4.  The method as claimed in claim 2 or 3, wherein the field device (1) is classified as non-functional if the measured voltage drop ($U_2$ - $U_1$) exceeds a predefined maximum voltage drop ($\Delta U_{max}$).

5.  The method as claimed in one of the preceding claims, wherein in the event that the capacitance (C) of the energy storage unit (14) is not below the defined minimum capacitance ($C_{min}$), a first change function (dC/dt) of the capacitance (C) is determined throughout progressing measuring cycles, and wherein a first remaining operating time ($\Delta t_1$) until the capacitance drops below the minimum capacitance ($C_{min}$) is calculated based on the current capacitance (C) and based on the change function (dC/dt).

6.  The method as claimed in at least one of the preceding claims, wherein in the event that the power consumption ($p_{11}$, $p_{12}$) at the energy storage unit (14) does not deviate from the defined standard consumption ($P_{norm}$), a second change function (dp/dt) of the power consumption ($p_{11}$, $p_{12}$) is determined throughout progressing measuring cycles, and wherein a second remaining operating time ($\Delta t_2$) until a minimum deviation from the standard consumption ($P_{min}$) is exceeded is calculated based on the current power consumption ($p_{11}$, $p_{12}$) and based on the second change function (dp/dt).

7.  The method as claimed in claim 4, wherein in the event that the measured voltage drop ($U_2$ - $U_1$) does not exceed the predefined maximum voltage drop ($\Delta U_{max}$), a third change function (dp/dt) of the voltage drop ($U_2$ - $U_1$) is determined throughout progressing measuring cycles, and wherein a third remaining operating time ($\Delta t_3$) until the maximum voltage drop ($\Delta U_{max}$) is exceeded is calculated based on the current voltage drop ($U_1$ - $U_2$) and based on the third change function (dU/dt).

8.  The method as claimed in claim 5, 6 or 7, wherein a suitable function type of the first change function (dC/dt), the second change function (dp/dt) and/or the third change function (dU/dt) is determined using the method of least squares.

9.  The method as claimed in one of the preceding claims, wherein a temperature is measured at the field device (1), and wherein the minimum capacitance ($C_{min}$) is defined as a function dependent on the temperature ($C_{min}(T)$).

10. A fill level meter for implementing the method as claimed in at least one of the preceding claims, wherein the fill level meter (1) comprises the following components for measuring a filling material (3) in a container (2):

    - An energy storage unit (14),
    - a signal generating unit (11) supplied with power by the energy storage unit (14), which is designed to transmit a radar or ultrasonic signal (SHF) towards the filling material (3),
    - an evaluation unit (12) supplied with power by the energy storage unit (14), which is designed to determine the fill level (L) using the signal (EHF) reflected on the surface of the filling material,
    - a control unit (13) which is designed to

        o switch the signal generating unit (11) and/or the evaluation unit (12) or individual function blocks thereof on and off,
        o determine the power consumption ($p_{11}$, $p_{12}$) at the energy storage unit (14), and
        o determine the capacitance (C) of the energy storage unit (14), and

• classify the field device (1) as non-functional if the capacitance (C) of the energy storage unit (14) drops below the minimum capacitance ($C_{min}$), or if the power consumption ($p_{11}$, $p_{12}$) deviates from the defined standard consumption (P norm)

**11.** The fill level meter as claimed in claim 10, wherein the control unit (13) is designed to calculate a remaining operating time ($\Delta t_1$, $\Delta t_2$) until the fill level meter (1) becomes non-functional, if the control unit (13) currently classifies the fill level meter (1) as functional, based on the measured capacitance (C) and/or based on the measured power consumption ($P_{11}$, $P_{12}$).

**12.** The fill level meter as claimed in claim 10 or 11, wherein the control unit (13) is designed to communicate any failure or a remaining operating time ($\Delta t_1$, $At_2$) to a higher-level unit (4).

**13.** The fill level meter as claimed in one of claims 10 to 12, wherein the energy storage unit (14) is designed as a buffer capacitor which can be connected to the higher-level unit (4) in particular for the purpose of recharging.

**Revendications**

**1.** Procédé destiné à la détermination de la capacité de fonctionnement d'un appareil de terrain (1), lequel appareil comprend au moins une unité électronique (11, 12) destinée à mesurer une grandeur de process (L), l'au moins une unité électronique (11, 12) étant alimentée au moyen d'un accumulateur d'énergie (14) de l'appareil de terrain (1), lequel procédé comprend les étapes suivantes :

- mesure de la capacité (C) de l'accumulateur d'énergie (14) après la mise hors circuit de l'au moins une unité électronique (11, 12), et
- mesure du prélèvement de puissance ($p_{11}$, $p_{12}$) sur l'accumulateur d'énergie (14) après la mise en marche de l'au moins une unité électronique (11, 12),

l'appareil de terrain (1) étant classé comme non fonctionnel dans la mesure où la capacité (C) de l'accumulateur d'énergie (14) est inférieure à une capacité minimale ($C_{min}$) définie, et dans la mesure où le prélèvement de puissance ($p_{11}$, $p_{12}$) s'écarte d'une consommation normale ($p_{norm}$) prédéfinie.

**2.** Procédé selon la revendication 1, pour lequel la capacité (C) est mesurée en mesurant en fonction du temps une chute de tension ($U_2$ - $U_1$) aux bornes de

l'accumulateur d'énergie (14) pendant une décharge définie de l'accumulateur d'énergie (14).

**3.** Procédé selon la revendication 1 ou 2, pour lequel, pour mesurer le prélèvement de puissance ($p_{11}$, $p_{12}$) sur l'accumulateur d'énergie (14) après la mise en marche de l'au moins une unité électronique (11, 12), on mesure la chute de tension ($U_2$ - $U_1$) en fonction du temps.

**4.** Procédé selon la revendication 2 ou 3, pour lequel l'appareil de terrain (1) est classé comme non fonctionnel dans la mesure où la chute de tension mesurée ($U_2$ - $U_1$) dépasse une chute de tension maximale ($\Delta U_{max}$) prédéfinie.

**5.** Procédé selon l'une des revendications précédentes,

pour lequel, dans le cas où la capacité (C) de l'accumulateur d'énergie (14) ne passe pas en dessous de la capacité minimale ($C_{min}$) définie, une première fonction de variation (dC/dt) de la capacité (C) est déterminée par des cycles de mesure progressifs, et
pour lequel, à l'aide de la capacité (C) actuelle ainsi qu'à l'aide de la fonction de variation (dC/dt), on calcule un premier temps de fonctionnement résiduel ($\Delta t_1$) jusqu'à ce que la capacité minimale ($C_{min}$) ne soit plus atteinte.

**6.** Procédé selon au moins l'une des revendications précédentes,

pour lequel, dans le cas où le prélèvement de puissance ($p_{11}$, $p_{12}$) sur l'accumulateur d'énergie (14) ne s'écarte pas de la consommation normale ($p_{norm}$) définie, une deuxième fonction de variation (dp/dt) du prélèvement de puissance ($p_{11}$, $p_{12}$), est déterminée par des cycles de mesure progressifs et
pour lequel, à l'aide du prélèvement de puissance ($p_{11}$, $p_{12}$) actuel ainsi qu'à l'aide de la deuxième fonction de modification (dp/dt), on calcule un deuxième temps de fonctionnement résiduel ($\Delta t_2$) jusqu'au dépassement d'un écart minimum par rapport à la consommation normale ($p_{norm}$).

**7.** Procédé selon la revendication 4,

pour lequel, dans le cas où la chute de tension mesurée ($U_2$ - $U_1$) ne dépasse pas la chute de tension maximale ($\Delta U_{max}$) prédéfinie, une troisième fonction de variation (dU/dt) de la chute de tension ($U_2$ - $U_1$) est déterminée par des cycles de mesure progressifs, et
pour lequel un troisième temps de fonctionnement résiduel ($\Delta t_3$) jusqu'au dépassement de la chute de tension maximale ($\Delta U_{max}$) est calculé à l'aide de la chute de tension ($U_1 - U_2$) actuelle ainsi qu'à l'aide de la troisième fonction de variation (dU/dt).

8. Procédé selon la revendication 5, 6 ou 7, pour lequel un type de fonction approprié de la première fonction de variation (dC/dt), de la deuxième fonction de variation (dp/dt) et/ou de la troisième fonction de variation (dU/dt) est déterminé au moyen de la méthode des moindres carrés.

9. Procédé selon l'une des revendications précédentes,

   pour lequel une température est mesurée sur l'appareil de terrain (1), et
   pour lequel la capacité minimale ($C_{min}$) est définie comme une fonction ($C_{min}(T)$) dépendant de la température.

10. Transmetteur de niveau destiné à la réalisation du procédé selon au moins l'une des revendications précédentes, le transmetteur de niveau (1) comprenant les composants suivants pour la mesure d'un produit (3) se trouvant dans un récipient (2) :

    - un accumulateur d'énergie (14),
    - une unité de génération de signaux (11) alimentée par l'accumulateur d'énergie (14), laquelle unité est conçue pour émettre un signal radar ou ultrasonore ($S_{HF}$) en direction du produit (3),
    - une unité d'exploitation (12) alimentée par l'accumulateur d'énergie (14), laquelle unité est conçue pour déterminer le niveau (L) à l'aide du signal ($E_{HF}$) réfléchi à la surface du produit,
    - une unité de commande (13), laquelle est conçue pour

      o commander l'unité de génération de signaux (11) et/ou l'unité d'exploitation (12) ou pour activer ou désactiver des blocs fonctionnels individuels de ceux-ci,
      o déterminer le prélèvement de puissance ($p_{11}$, $p_{12}$) sur l'accumulateur d'énergie (14) et
      o déterminer la capacité (C) de l'accumulateur d'énergie (14), et
      o classer l'appareil de terrain (1) comme non fonctionnel, dans la mesure où la capacité (C) de l'accumulateur d'énergie (14) est inférieure à la capacité minimale ($C_{min}$), ou dans la mesure où le prélèvement de puissance ($p_{11}$, $p_{12}$) s'écarte de la consommation normale ($p_{norm}$) définie.

11. Transmetteur de niveau selon la revendication 10,
    pour lequel l'unité de commande (13) est conçue pour calculer, sur la base de la capacité mesurée (C) et/ou sur la base du prélèvement de puissance mesuré ($p_{11}$, $p_{12}$), un temps de fonctionnement résiduel ($\Delta t_1$, $\Delta t_2$) jusqu'à l'incapacité de fonctionnement du transmetteur de niveau (1), dans la mesure où l'unité de commande (13) estime que le transmetteur de niveau (1) est actuellement capable de fonctionner.

12. Transmetteur de niveau selon la revendication 10 ou 11, pour lequel l'unité de commande (13) est conçue pour transmettre une éventuelle incapacité de fonctionnement ou un temps de fonctionnement résiduel ($\Delta t_1$, $\Delta t_2$) à une unité supérieure (4).

13. Transmetteur de niveau selon l'une des revendications 10 à 12, pour lequel l'accumulateur d'énergie (14) est conçu comme un condensateur tampon qui peut être relié notamment à l'unité supérieure (4) pour être rechargé.

$$S_{HF}$$

$$E_{HF}$$

**Fig. 1**

Fig. 2

$S_{HF}$

$E_{HF}$

Diagnose/
Prognose

↓

Abschaltung
el. Einheiten

↓

$C < C_{min}?$ —— nein ——→ Einschalten Einheit 11

Einschalten Einheit 11 ↓ $p_{11} \sim p_{11,norm}?$ —— ja ——→ Einschalten Einheit 12

Einschalten Einheit 12 ↓ $p_{12} \sim p_{12,norm}?$ —— ja ——→ Funktions-tüchtig

ja ↓

Speicher 14
defekt

dC/dt

nein ↓

Einheit 11
defekt

$dp_{11}/dt$

nein ↓

Einheit 12
defekt

$dp_{12}/dt$

Δt

**Fig. 3**

**Fig. 4**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2007205772 A1